# EUROPÄISCHE PATENTSCHRIFT

(11) **EP 1 670 875 B1**
(45) Veröffentlichungstag und Bekanntmachung des Hinweises auf die Patenterteilung: **14.08.2019**
(21) Anmeldenummer: 04786851.8
(22) Anmeldetag: 24.09.2004
(51) Int. Cl.: C09K 11/79, H01L 33/00

(54) **HOCHEFFIZIENTES BELEUCHTUNGSSYSTEM AUF LED-BASIS MIT VERBESSERTER FARBWIEDERGABE**
HIGHLY EFFICIENT LED-BASED ILLUMINATION SYSTEM FEATURING IMPROVED COLOR RENDERING
SYSTEME D'ECLAIRAGE HAUTEMENT EFFICACE A BASE DE DIODES ELECTROLUMINESCENTES PRESENTANT UN MEILLEUR RENDU DES COULEURS

(30) Priorität: 24.09.2003 DE 10344332
(43) Veröffentlichungstag der Anmeldung: 21.06.2006
(73) Patentinhaber: Patent-Treuhand-Gesellschaft für elektrische Glühlampen mbH, 81543 München (DE); OSRAM Opto Semiconductors GmbH, 93055 Regensburg (DE)
(72) Erfinder: BRUNNER, Herbert, 93161 Sinzing (DE); FIEDLER, Tim, 81377 München (DE); JERMANN, Frank, 81739 München (DE); ZACHAU, Martin, 82269 Geltendorf (DE)
(74) Vertreter: Epping - Hermann - Fischer
(86) Internationale Anmeldenummer: PCT/DE2004/002135
(87) Internationale Veröffentlichungsnummer: WO 2005/030903

(56) Entgegenhaltungen:
- EP-A- 1 104 799
- EP-A- 1 264 873
- EP-A- 1 413 618
- WO-A-2004/030109
- US-A- 4 897 319

## Beschreibung

### Technisches Gebiet

Die Erfindung geht aus von einem hocheffizienten Beleuchtungssystem auf LED-Basis mit verbesserter Farbwiedergabe. Es handelt sich dabei insbesondere um Lumineszenzkonversions-LEDs, die insbesondere voll durchstimmbar sind.

### Stand der Technik

Ein Konzept für ein hocheffizientes Beleuchtungssystem auf LED-Basis mit verbesserter Farbwiedergabe ist die Dreifarbenmischung. Hierbei wird zur Erzeugung von weiß die Mischung der Grundfarben Rot-Grün-Blau (RGB) herangezogen. Dabei kann eine blaue LED zur teilweisen Konversion zweier Leuchtstoffe, die rot und grün emittieren, herangezogen werden. Die Suche nach einem effizienten Grünleuchtstoff für ein RGB-System steht derzeit im Mittelpunkt, wie beispielsweise der Vorschlag aus US 6 255 670 zeigt. Alternativ wird eine UV-emittierende LED verwendet, die drei Leuchtstoffe, die jeweils ihre Emission im Roten, Grünen und Blauen haben, angeregt, siehe WO 97/48138. Beispiele sind Linienemitter wie YOB:Ce,Tb (grün) und YOS:Eu (rot). Hierbei ist eine relativ kurzwellige Emission (UV-Bereich < 370 nm) erforderlich, um hohe Quantenausbeuten erreichen zu können. Dies bedingt den Einsatz von Saphir-Substraten für die UV-LED, die sehr teuer sind. Verwendet man andererseits eine UV-LED auf Basis der billigeren SiC-Substrate, so muss man sich mit einer Emission im Bereich 380 bis 420 nm zufriedengeben. Die einzelnen Farben des Systems RGB können grundsätzlich durch die primäre Strahlung von LEDs oder durch Lumineszenzkonversions-LED erzeugt werden, wie WO 01/41215 illustriert.

Um die gesamte Lichtausbeute zu steigern, wurde auch ein kompliziertes System unter Einschluss einer vierten LED, die im Bereich 575 bis 605 emittiert, in der WO 00/19141 vorgeschlagen. Natürlich ist ein derartiges System wesentlich aufwendiger, teurer und komplizierter als ein RGB-System.

Ein etwas anderes Konzept zeigt die DE-OS 101 37 042, die ein planares Beleuchtungssystem mit spezieller Einkopplung des blauen Anteils vorstellt, um die üblichen Absorptionsprobleme mit blauen Leuchtstoffen zu vermeiden.

Eine interessante Klasse von Leuchtstoffen für derartige Beleuchtungssysteme sind die des Typs Oxinitridosilikat, wie sie an sich unter der Kurzformel MSiON bekannt sind; siehe beispielsweise "On new rare-earth doped M-Si-Al-O-N materials", J. van Krevel, TU Eindhoven 2000, ISBN 90-386-2711-4, Kap. 6. Sie sind mit Tb dotiert. Emission wir erreicht bei Anregung durch 365 nm oder 254 nm.

WO 2004/030109 (Art. 54(3)) und EP 1 413 618 (Art. 54(3)) beschreiben ein Beleuchtungssystem, bei dem einer LED mindestens ein Leuchtstoff vorgeschaltet ist.

### Darstellung der Erfindung

Es ist Aufgabe der vorliegenden Erfindung, ein Beleuchtungssystem auf LED-Basis mit verbesserter Farbwiedergabe gemäß dem Oberbegriff des Anspruchs 1 bereitzustellen, dessen Farbwiedergabe möglichst hoch ist. Eine weitere Aufgabe ist, ein durchstimmbares Beleuchtungssystem anzugeben.

Diese Aufgabe wird durch die kennzeichnenden Merkmale des Anspruchs 1 gelöst. Besonders vorteilhafte Ausgestaltungen finden sich in den abhängigen Ansprüchen.

Für bestimmte Anwendungen ist der Einsatz von RGB-LEDs interessant, die aus drei Chips mit den Emissionsfarben RGB bestehen. Da alle drei Farben durch verschiedene LEDs realisiert sind, können alle drei Komponenten unabhängig voneinander angesteuert werden. Daher ist es mit dieser Art von Beleuchtungssystem möglich nahezu jeden gewünschten Farbort über eine entsprechende Steuerelektronik gezielt einzustellen. Ein Nachteil dieser Lösung ist ein sehr niedriger Farbwiedergabeindex Ra < 50, der sich aufgrund der Schmalbandigkeit der drei Einzelemissionen ergibt. Ein weiterer Nachteil ist, dass die eingesetzte Grün-LED aus technologischen Gründen deutlich weniger effizient ist als die anderen beiden Komponenten, Hinzu kommt, dass der Farbort stark vom Betriebsstrom und der Temperatur abhängt. Derzeitige Technologie (InGaN-LED für blau 430 bis 470 nm bzw. InGa-AIP-LED für gelb > 540 nm insbesondere rot im Bereich 600 bis 700 nm) hat für die Primärstrahlung einer LED im grünen Spektralbereich keine überzeugende Lösung. Der Vorteil der mit Primärstrahlung realisierten RGB-Lösung ist allerdings, dass derartige Beleuchtungssysteme durchstimmbar sind.

Dagegen werden für Beleuchtungssysteme, bei denen eine hohe Anforderung an die Farbwiedergabe im Vordergrund steht, LEDs verwendet, bei denen ein Teil der primären LED-Emission in längerwelliges Licht, vor allem grün, konvertiert wird. Allerdings ist dieser Aufbau nicht durchstimmbar, weil die sekundäre Komponente nicht unabhängig von der primären Komponente ist.

Bisher gibt es keinen grün emittierenden Leuchtstoff hoher Effizienz, der gleichzeitig unempfindlich gegen äußere Einflüsse ist.

Das erfindungsgemäße Beleuchtungssystem nutzt gleichzeitig das Farbmischprinzip aus blau, grün und rot (RGB-Mischung) und das Prinzips der Konversion einer primär von einer LED emittierten Strahlung in längerwelliges Licht durch einen diese Strahlung absorbierenden Leuchtstoff aus, wobei mindestens zwei LEDs verwendet werden, von denen eine erste LED primär im Bereich 340 bis 470 nm (Peakwellenlänge) emittiert, insbesondere bei mindestens 420 nm, und eine zweite LED im roten Bereich bei 600 bis 700 nm (Peakwellenlänge) emittiert, wobei die grüne Komponente dadurch erzeugt wird, dass die Primärstrahlung der ersten LED zumindest teilweise von einem grün emittierenden Leuchtstoff konvertiert wird, wobei als grün emittierender Leuchtstoff ein Leuchtstoff aus der Klasse der Oxinitridosilikate verwendet wird, mit einem Kation M und der grundsätzlichen Formel M_{(1-c)}Si₂O₂N₂:D_{c}, wobei M als Bestandteil Sr umfast und wobei D mit zweiwertigem Europium dotiert ist, wobei M = Sr, oder M = Sr_{(1-x-y)}Ba_{y}Caₓ mit x+y < 0,5 verwendet wird, wobei das Oxinitridosilikat vollständig oder überwiegend aus der hochtemperaturstabilen Modifikation HT besteht

Es wird die Verwendung eines Leuchtstoffs vorgeschlagen, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also mit mehr als 50 % des Leuchtstoffs, aus der HT-Phase besteht. Diese HT-Modifikation zeichnet sich dadurch aus, dass sie breitbandig anregbar aus, dass sie eine extrem hohe Stabilität gegen äußere Einflüsse besitzt, also bei 150°C keine messbare Degradation zeigt, dass sie eine extrem gute Farbortstabilität unter wechselnden Bedingungen zeigt (zwischen 20 und 100 °C wenig Drift nachweisbar). Weitere Pluspunkte sind seine geringe Absorption im Roten, was besonders bei Leuchtstoffmischungen vorteilhaft ist. Dieser Leuchtstoff wird im folgenden oft Sr-Sion:Eu genannt.

Bei der Herstellung des neuartigen Leuchtstoffs kommt es vor allem auf eine hohe Temperatur an, der Synthesebereich liegt bei 1300 bis 1600 °C. ein anderer bestimmender Faktor ist die Reaktivität der Ausgangskomponenten. Diese sollte möglichst hoch sein.

Der aus EP-PA 02 021 117.8 bekannte Leuchtstoff MSi₂O₂N₂:Eu (M = Ca, Sr, Ba) ist im Falle der Sr-dominierten Ausführungsform mit M= Sr oder M = Sr_{(1-x-y)}Ba_{y}Caₓ mit x+y < 0,5 , im folgenden Sr-Sion genannt, nur schwer beherrschbar. Obwohl einzelne Versuchsbedingungen hervorragende Ergebnisse liefern, fehlt bislang eine Richtschnur, um zuverlässig gewünschte Ergebnisse zu erhalten. Hinzu kommt eine gewisse Neigung, dass sich bei hoher Temperaturbelastung die Effizienz des Leuchtstoffs verringert und der Farbort zu stark variiert.

Überraschenderweise hat sich nun gezeigt, dass sich die beiden Phasen in ihrer Eignung als Leuchtstoff grundlegend unterscheiden. Während die NT-Phase als Eudotierter Leuchtstoff nur bedingt zu gebrauchen ist, und eher orange-rot emittiert, zeigt die HT-Phase eine hervorragende Eignung als Leuchtstoff, der grün emittiert. Häufig liegt eine Mischung beider Modifikationen vor, die breitbandig beide Emissionen erkennen lässt. Gewünscht ist daher, die HT-Phase möglichst rein, mit mindestens 50 % Anteil, bevorzugt mindestens 70 %, besonders bevorzugt mindestens 85% Anteil herzustellen.

Dafür ist ein Glühprozess erforderlich, der bei mindestens 1300 °C, aber nicht mehr als 1600 °C durchgeführt wird. Bevorzugt ist ein Temperaturbereich von etwa 1450 bis 1580 °C, da bei geringerer Temperatur zunehmend NT-Phase entsteht und bei höherer Temperatur der Leuchtstoff zunehmend schlechter verarbeitbar ist, und ab etwa 1600 °C als hart gesinterte Keramik oder Schmelze vorliegt. Der optimale Temperaturbereich hängt von der genauen Zusammensetzung und den Eigenschaften der Ausgangsmaterialien ab.

Besonders wichtig für das Herstellen eines effizienten Leuchtstoffs des Typs Sr-Sion ist ein Ansatz der Ausgangsprodukte, der im wesentlichen stöchiometrisch ist unter Verwendung der Grundkomponenten SiO₂, SrCO₃ sowie Si₃N₄. Sr steht hier beispielhaft stellvertretend für M. Die Abweichung sollte insbesondere 10 %, bevorzugt 5 %, des idealen stöchiometrischen Ansatzes nicht überschreiten, wobei auch die etwaige Zugabe eines Schmelzmittels, wie es oft üblich ist, dabei eingeschlossen ist. Besonders bevorzugt ist eine maximale Abweichung von 1 %. Hinzu kommt ein Vorläufer für den Europium-Beitrag der Dotierung, der beispielsweise als Oxid Eu₂O₃ realisiert wird. Diese Erkenntnis steht im Gegensatz zu der bisherigen Vorgehensweise, die Grundkomponente SiO₂ deutlich unterstöchiometrisch zuzugeben. Besonders überraschend ist diese Erkenntnis auch deswegen, weil andere als Leuchtstoff empfohlene Sione wie Ba-Sion gemäß der Lehre von EP-PA 02 021 117.8 gerade im SiO₂-Unterschuss hergestellt werden sollen.

Ein entsprechender Ansatz für das Sr-Sion MSi₂O₂N₂ verwendet daher 11 bis 13 Gew.-% SiO₂, 27 bis 29 Gew.-% Si₃N₄, Rest SrCO₃. Ba- und Ca- Anteile an M werden entsprechend als Carbonat zugesetzt. Europium wird entsprechend der gewünschten Dotierung, beispielsweise als Oxid oder Fluorid, als Ersatz für SrCO₃ zugesetzt. Der Ansatz MSi₂O₂N₂ meint dabei auch etwaige Abweichungen von der exakten Stöchiometrie, soweit sie hinsichtlich der Ladungserhaltung ausgeglichen sind.

Als besonders günstig hat sich erwiesen, dass die Ausgangskomponenten des Wirtsgitters, insbesondere Si₃N₄, möglichst hohe Reinheit besitzen. Besonders bevorzugt ist daher Si₃N₄, das aus der flüssigen Phase, ausgehend beispielsweise von Siliziumtetrachlorid, synthetisiert ist. Als kritisch hat sich insbesondere die Verunreinigung mit Wolfram und Kobalt, erwiesen. Hier sollte die Verunreinigung möglichst gering sein, insbesondere sollte sie jeweils kleiner 100 ppm, insbesondere kleiner 50 ppm, sein, bezogen auf diese Vorläufersubstanzen. Des weiteren ist eine möglichst hohe Reaktivität vorteilhaft, sie lässt sich durch die reaktive Oberfläche (BET) quantifizieren. Diese sollte mindestens 6 m²/g betragen, vorteilhaft mindestens 8 m²/g. Auch die Verunreinigung an Aluminium und Calcium, bezogen auf diese Vorläufersubstanz Si₃N₄, sollte möglichst unter 100 ppm liegen.

Bei Abweichung von der oben angegebenen Verfahrensführung in bezug auf stöchiometrischen Ansatz und Temperaturführung entstehen als unerwünschte Fremdphasen in zunehmendem Maße Nitridosilikate MxSiyNz wie etwa M2Si5N8, wenn die SiO₂-Zugabe zu niedrig angesetzt wird, so dass ein Stickstoffüberschuss entsteht. Obwohl diese Verbindung an sich ein bemerkenswerter Leuchtstoff ist, ist sie in Zusammenhang mit der Synthese des Sr-Sions genauso wie andere Nitridosilikate äußerst störend, weil diese Fremdphasen die grüne Strahlung des Sr-Sions absorbieren und evtl. in die bekannte rote Strahlung der Nitridosilikate umwandeln. Umgekehrt entstehen bei zu hoher SiO₂-Zugabe Sr-Silikate wie beispielsweise Sr₂SiO₄ weil ein Sauerstoffüberschuss entsteht. Beide Fremdphasen absorbieren die nutzbare grüne Emission oder führen zumindest zu Gitterdefekten wie Leerstellen, die die Effizienz des Leuchtstoffs stark beeinträchtigen. Als Anhaltspunkt dient die Richtschnur, dass der Anteil der Fremdphasen möglichst unter 15 %, bevorzugt sogar unter 5 %, liegen soll. Dies korrespondiert im XRD-Spektrum des synthetisierten Leuchtstoffs mit der Forderung, dass beim XRD-Ablenkwinkel 2 Θ im Bereich 25 bis 32° die Intensität aller Fremdphasenpeaks kleiner als 1/3, bevorzugt kleiner als ¼, besonders bevorzugt kleiner als 1/5, der Intensität des die HT-Modifikation kennzeichnenden Hauptpeaks bei etwa 31,8° sein soll. Dies gilt vor allem für die Fremdphasen vom Typ SrxSiyNz, insbesondere Sr2Si5N8.

Im Falle einer optimierten Verfahrensführung lässt sich zuverlässig eine Quanteneffizienz von 80 bis deutlich über 90 % erzielen. Dagegen wird bei unspezifischer Verfahrensführung die Effizienz typisch im Bereich von höchstens 50 bis 60 % Quanteneffizienz liegen.

Erfindungsgemäß lässt sich somit ein Leuchtstoff herstellen, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also zu mehr als 50 % des Leuchtstoffs, bevorzugt zu mehr als 85% des Leuchtstoffs, aus der HT-Phase besteht. Diese HT-Modifikation zeichnet sich dadurch aus, dass sie breitbandig anregbar ist, nämlich in einem weiten Bereich von 50 bis 480 nm, insbesondere 150 bis 480 nm, besonders bevorzugt von 250 bis 470 nm, dass er eine extrem hohe Stabilität gegen äußere Einflüsse besitzt, also bei 150°C an Luft keine messbare Degradation zeigt, und dass er eine extrem gute Farbortstabilität unter wechselnden Bedingungen zeigt. Weitere Pluspunkte sind seine geringe Absorption im Roten, was besonders bei Leuchtstoffmischungen vorteilhaft ist. Dieser Leuchtstoff wird im folgenden oft Sr-Sion:Eu genannt. Ein Überwiegen der HT-Modifikation ist u.a. daran erkennbar, dass der kennzeichnende Peak der NT-Modifikation im XRD-Spektrum bei etwa 28,2 ° eine Intensität von weniger als 1:1, bevorzugt weniger als 1:2, im Vergleich zum Peak mit höchster Intensität aus der Dreiergruppe der Reflexe der HT-Modifikation, die im XRD-Spektrum bei 25 bis 27° liegen, aufweist. Die hier aufgeführten XRD-Spektren beziehen sich jeweils auf eine Anregung durch die bekannte Cu-K_{α} Linie.

Bei gleicher Aktivatorkonzentration zeigt dieser Leuchtstoff ein anderes Emissionsverhalten als die NT-Variante gleicher Stöchiometrie. Die Halbwertsbreite der HT-Variante ist im Falle der optimierten HT-Variante wesentlich geringer als bei der einfachen fremdphasen- und defekthaltigen Mischung und liegt im Bereich 70 bis 80 nm, während die einfache Fremdphasen- bzw. defekthaltige Mischung eine Halbwertsbreite von etwa 110 bis 120 nm zeigt. Die dominante Wellenlänge ist bei der HT-Modifikation generell kürzer, typisch 10 bis 20 nm kürzer, als bei einer deutlich fremdphasenhaltigen Probe. Hinzu kommt, dass die Effizienz der hochreinen HT Modifikation typisch um mindestens 20 % höher, teilweise deutlich noch höher, als bei der NT-dominierten oder hoch fremdphasenhaltigen Mischung liegt.

Ein kennzeichnendes Merkmal eines ausreichend geringen Anteils der NT-Modifikation und Fremdphasen ist eine Halbwertsbreite (FWHM) der Emission von weniger als 90 nm. Denn je geringer der Anteil an Fremdphasen, desto geringer ist der Anteil der spezifischen orange-roten Emission der fremdphasenreichen Modifikation, insbesondere der Nitridosilikat-Fremdphasen Sr-Si-N-Eu wie vor allem Sr2Si5N8:Eu.

Hilfreich zur Charakterisierung sind neben der verringerten Halbwertsbreite die oben angegebenen typischen Reflexe im XRD-Spekrum, die die andere Kristallstruktur verdeutlichen.

Der vorherrschende Peak im XRD-Spektrum der HT-Modifikation ist der Peak bei etwa 31.7°. weitere prominente Peaks sind die drei Peaks etwa gleicher Intensität zwischen 25 und 27° (25,3 und 26,0 und 26,3°), wobei der Peak mit kleinster Ablenkung der intensivste ist. ein weiterer intensiver Peak ist 12,6°.

Dieser Leuchtstoff ist vor allem grün emittierend mit einer Dominanzwellenlänge im Bereich 550 bis 570 nm, insbesondere 555 bis 565 nm.

Auch eine geringfügige Beimengung der Gruppe AIO als Ersatz der Gruppe SiN im Molekül des Oxinitridosilikats der Formel MSi₂O₂N₂ ist möglich, insbesondere bis maximal 30 % des SiN-Anteils.

Beide Phasen des Sr-Sion:Eu können analog zu den zwei strukturell unterschiedlichen Wirtsgittermodifikationen kristallisieren und jeweils über die Ansatzstöchiometrie SrSi2O2N2:Eu hergestellt werden. Geringe Abweichungen von dieser Stöchiometrie sind möglich. Die mit Eu dotierten Wirtsgitter lumineszieren überraschenderweise beide bei Anregung im Blauen oder UV, allerdings je nach Wirtsgittermodifikation mit anderer Emissionsfarbe. Die NT-Modifikation zeigt eine orangefarbene Emission, die HT-Modifikation eine grüne Emission bei etwa λ_{dom} = 560 nm mit prinzipiell deutlich höherer Effizienz. Je nach Dotiergehalt und Dotiermaterial (Eu oder Eu, Mn) sowie den relativen Anteilen der HT- und NT-Modifikation lässt sich eine gewünschte Eigenschaft des Leuchtstoffs genau einstellen.

Ein Vorzug der HT-Phase ist die über einen sehr weiten Spektralbereich gleichmäßig gute Anregbarkeit bei nur wenig variierender Quanteneffizienz.

Außerdem hängt die Lumineszenz der HT-Modifikation in einem weiten Temperaturbereich nur schwach von der Temperatur ab. Damit ist erstmals ein grün emittierender Leuchtstoff, bevorzugt für LED-Anwendungen, gefunden, der ohne besondere Maßnahmen zur Stabilisierung auskommt. Dies zeichnet ihn besonders gegen die bisher als aussichtsreichste Kandidaten angesehenen Leuchtstoffe für diese Aufgabe aus, nämlich Thiogallat-Leuchtstoffe oder Chlorosilikate.

Die Sionverbindungen mit M = (Sr,Ba), bevorzugt ohne Ba oder mit Ba-Anteil bis zu 10 %, stellen effiziente Leuchtstoffe mit einem weiten Bereich der Emissionsmaxima dar. Diese liegen meist kurzwelliger als bei reinem Sr-Sion, bevorzugt zwischen 520 und 565 nm. Der erreichbare Farbraum lässt sich außerdem durch geringe Beigaben (bevorzugt bis 30 mol-%) an Ca und/oder Zink erweitern; dadurch werden die Emissionsmaxima eher in den langwelligeren Bereich, verglichen mit reinem Sr-Sion, verschoben, sowie durch partiellen Ersatz (bis 25 mol-%) von Si durch Ge und/oder Sn.

Eine weitere Ausführungsform ist die Teilsubstitution von M, insbesondere Sr, durch drei- oder einwertige Ionen wie Y3+, La3+ oder Li+ bzw. Na+. Bevorzugt ist ein Anteil dieser Ionen von maximal 20 mol-% des M.

Insbesondere entfaltet dieser Leuchtstoff Vorteile bei der Verwendung in einem Beleuchtungssystem, wobei er als grüner Leuchtstoff bisherige ineffiziente Lösungen für die grüne Komponenten ersetzt. Die Anregung des Leuchtstoffs erfolgt dabei entweder durch eine blaue LED mit hocheffizienter Primärstrahlung, oder auch durch eine UV-LED. Da die grüne Emission relativ breitbandig ist, verglichen mit anderen technologischen Lösungen wie Thiogallaten oder Chlorosilikaten, stellt sich ein deutlich gestiegener Farbwiedergabeindex ein.

Dieser Leuchtstoff eignet sich besonders gut für die Anwendungen bei vollfarbtauglichen Lumineszenzkonversions-LEDs sowie Lumineszenzkonversions-LEDs mit beliebig einstellbaren Farben auf Basis eine UV-Blau primär emittierenden LED. Die Konversion durch den erfindungsgemäßen Leuchtstoff liefert blaugrün bis grüngelbliche Farben.

Die Mischverbindungen mit M = (Sr,Ba) stellen effiziente Leuchtstoffe mit einem weiten Bereich der Emissionsmaxima dar. Diese liegen zwischen 520 und 570 nm. der erreichbare Farbraum lässt sich außerdem durch geringe Beigaben (bevorzugt bis 30 mol-%) an Ca und/oder Zink erweitern, sowie durch partiellen Ersatz (bis 25 mol-%) von Si durch Ge und/oder Sn.

Eine weitere Ausführungsform ist die Teilsubstitution von M, insbesondere Sr, durch drei- oder einwertige Ionen wie La3+ oder Li+. Bevorzugt ist ein Anteil von maximal 20 mol-% des M.

Bevorzugt lässt sich der erfindungsgemäße Leuchtstoff für Lumineszenzkonversions-LED zur Erzeugung von weißem Licht einsetzen, sei es mit blauer Primärstrahlung, aber auch mit UV-Primärstrahlung, wobei mittels blau und gelbgrün emittierender Leuchtstoffe weißes Licht erzeugt wird. Kandidaten für die blaue Komponente sind an sich bekannt, beispielsweise eignen sich BaMgAl₁₀O₁₇:Eu²⁺ (bekannt als BAM) oder Ba₅SiO₄(Cl,Br)₆:Eu²⁺ oder CaLa₂S₄:Ce³⁺ oder auch (Sr,Ba,Ca)₅(PO₄)₃Cl:EU²⁺ (bekannt als SCAP). Als gelbgrüne Komponente eignet sich der erfindungsgemäße Leuchtstoff.

Zur Farbverbesserung dieses Systems wird zusätzlich ein Rotleuchtstoff eingesetzt. Bevorzugt ist die Anwendung einer zusätzlichen primär rot emittierenden LED. Er wird insbesondere zusammen mit einer blau emittierenden Basis-LED verwendet, besonders geeignet sind ((Y,La,Gd,Lu)₂O₂S:Eu³⁺, SrS:Eu²⁺ oder auch (Ca,Sr)₂Si₅N₈ :Eu²⁺, insbesondere mit hohem Ca-Anteil.

Auf diese Weise lassen sich, insbesondere in weiten Bereichen bei warmweißen Lichtfarben entsprechend einer Farbtemperatur von 2200 bis 3500 K, Werte des Farbwiedergabeindex Ra von 85 bis 95 erzielen, ohne dabei die Dimmbarkeit des Beleuchtungssystems einzubüßen.

Die gefundene Lösung ist also nunmehr beiden Teilaspektlösungen überlegen, da sie eine höhere Effizienz als das bisherige effizienzoptimierte System und eine schlagartig bessere Lösung des dimmbaren Systems ermöglicht. Daher wird insgesamt ein Durchbruch für diese Technologie erzielt.

Besonders bevorzugt ist ein Beleuchtungssystem in RGB-Technik, das nur nitridbasierte Leuchtstoffe verwendet, indem eine hocheffiziente blaue LED mit dominanter Wellenlänge von 440 bis 465 nm, bevorzugt mit 460 nm Peakwellenlänge, zusammen mit Lumineszenzkonversions-LEDs verwendet. Eine erste Lumineszenzkonversions-LED verwendet eine blaue LED, bevorzugt mit 460 nm Peakwellenlänge, als primäre Lichtquelle, unter Konversion mittels des oben beschriebenen Sr-Sions als grüner Sekundär-Lichtquelle. Eine zweite Lumineszenzkonversions-LED verwendet eine blaue LED, bevorzugt mit etwa 460 nm Peakwellenlänge, als primäre Lichtquelle, unter Konversion mittels eines Nitridosilikats vom Typ (Ca,Sr)₂Si₅N₈:Eu²⁺ als roter Sekundär-Lichtquelle. Überraschenderweise ergänzen sich diese drei Komponenten nahezu ideal in ihrem Spektrum, so dass die hohe Farbwiedergabe bei hoher Effizienz möglich wird.

Die technische Realisierung des erfindungsgemäßen Beleuchtungssystems kann auf mehrere Arten erfolgen. Insbesondere sind sog. Multichip-LEDs von Interesse, hier befinden sich die verschiedenen Chips in einem Gehäuse. In aller Regel handelt es sich dabei um zwei oder drei Chips. Prinzipiell sind folgende Realisierungen möglich:
Die erste LED ist in einer ersten Ausführungsform eine primär im Bereich 340 bis 430 nm emittierende UV-LED, die den grünen Leuchtstoff zur sekundären Emission anregt. Die zweite LED ist die rot emittierende LED. Außerdem wird eine dritte LED verwendet, die bevorzugt selbst primär blau emittiert (430 bis 470 nm Peak) oder auch bei der ein blauer Leuchtstoff von einer primär UV emittierenden LED angeregt wird.

In einer zweiten Ausführungsform werden nur zwei LEDs verwendet. Dabei ist die erste LED entweder primär UV emittierend im Bereich 340 bis 420 nm, wobei ihr ein blau emittierender Leuchtstoff und der neuartige grün emittierende Leuchtstoff vorgeschaltet sind. Diese beiden Leuchtstoff konvertieren die UV Strahlung der ersten LED vollständig. Bevorzugt ist aber eine Ausführung, bei der die erste LED eine blau emittierende LED mit Peak im Bereich 430 bis 470 nm ist, der ein neuartiger grün emittierender Leuchtstoff vorgeschaltet ist, der das primäre Licht der LED teilweise in grüne Sekundärstrahlung umwandelt. Die zweite LED ist wieder die rot emittierende LED. Selbstverständlich ist nicht ausgeschlossen, dass auch der rote Anteil durch Konversion einer kürzerwelligen Strahlung erzeugt wird, beispielsweise einer UV-LED oder blauen LED.

Die hier beschriebenen LEDs können selbstverständlich auch als Gruppen von gleichartigen LEDs verstanden werden.

Die einzelnen Chips sind dabei lokal mit dem jeweiligen Leuchtstoff versehen. Die einzelnen Chips können sich zu diesem Zweck in verschiedenen Hohlräumen oder Kavitäten oder zusammen in einer einzigen Kavität befinden. Dabei werden die Chips normalerweise bereits in einem Vorprozess mit dem Leuchtstoff versehen. Bei der Lösung mit einer einzigen Kavität oder einer Lösung, bei der der Leuchtstoff physikalisch getrennt vom Chip angeordnet ist, kann das Auftragen des Leuchtstoffs auch erst nach dem Einbau der Chips in das Gehäuse des Beleuchtungssystems erfolgen. Die beschriebenen Leuchtstoffe sind insbesondere für Techniken der chipnahen Konversion geeignet, wie sie an sich in der Literatur bekannt sind, siehe beispielsweise DE 102 03 795.

Die Erfindung betrifft weiterhin ein Beleuchtungssystem mit LEDs wie oben beschrieben, wobei das Beleuchtungssystem weiterhin elektronische Komponenten enthält. diese vermitteln beispielsweise die Dimmbarkeit. Eine weitere Aufgabe der Elektronik ist die Ansteuerung einzelner LEDs oder auch Gruppen von LEDs. Diese Funktionen können durch vorbekannte elektronische Elemente realisiert sein.

### Figuren

Im folgenden soll die Erfindung anhand zweier Ausführungsbeispiele näher erläutert werden. Es zeigen:
- Figur 1: ein Emissionsspektrum eines Oxinitridosilikats;
- Figur 2: das Reflektionsspektrum dieses Oxinitridosilikats;
- Figur 3: ein Beleuchtungssystem mit mehreren Halbleiterbauelementen, das als Lichtquelle für weißes Licht dient (Fig. 3b), wobei ein Halbleiterbauelement auch in Vergrößerung (Fig. 3a) gezeigt ist;
- Figur 4: ein Emissionsspektrum des Halbleiterbauelements aus Figur 3;
- Figur 5: ein zweites Ausführungsbeispiel eines Halbleiterbauelements.

### Beschreibung der Zeichnungen

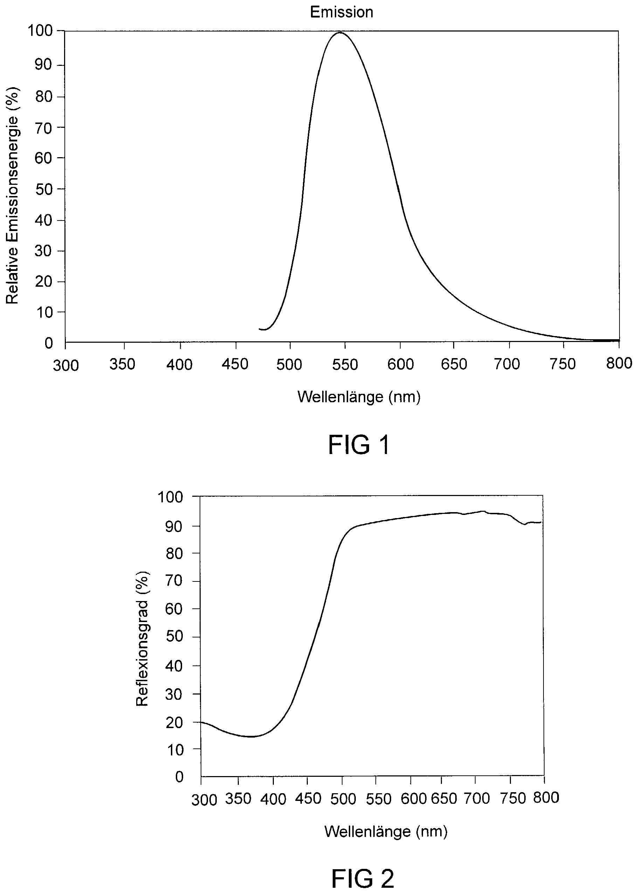

Ein konkretes Beispiel für den hocheffizienten grün emittierenden Leuchtstoff ist in Figur 1 gezeigt. Es handelt sich um die Emission des Leuchtstoffs SrSi₂N₂O₂:(10 % Eu²⁺) in HT-Modifikation, bei dem der Eu-Anteil 10 mol-% der von Sr besetzten Gitterplätze ausmacht. Das Emissionsmaximum liegt bei 545 nm, die mittlere dominante Wellenlänge bei 564 nm (λdom). Der Farbort ist x=0,393; y=0,577. Die Anregung erfolgt bei 460 nm. Die FWHM ist 84 nm.

Figur 2 zeigt das diffuse Reflexionsspektrum dieses Leuchtstoffs. Es zeigt ein ausgeprägtes Minimum im Bereich unter 430 nm, das somit die gute Anregbarkeit in diesem Bereich demonstriert.

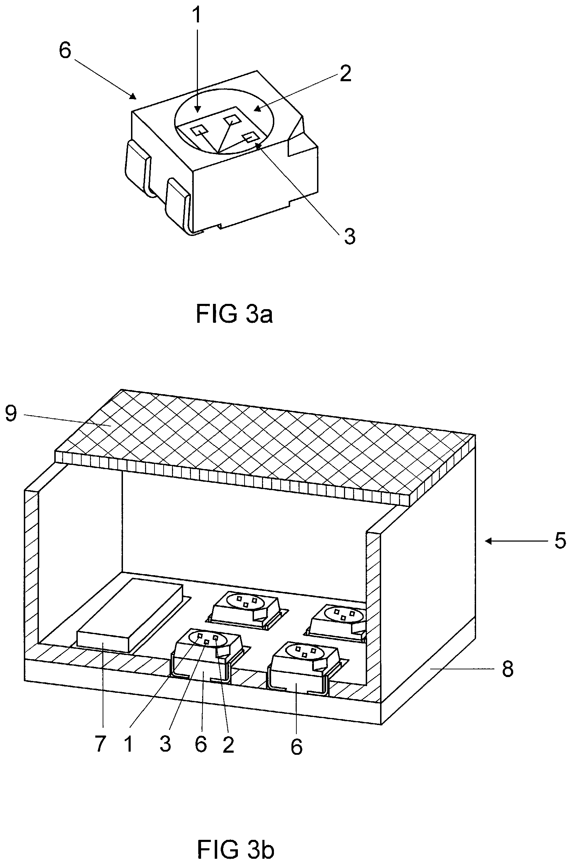

Der Aufbau einer Lichtquelle für weißes Licht ist in Figur 3a, 3b explizit gezeigt. Die Lichtquelle, siehe Figur 3b, ist ein Halbleiterbauelement 6 vom Typ LED mit einem ersten Chip 1 des Typs InGaN mit einer Peakemissionswellenlänge von beispielsweise 460 nm, sowie einem zweiten Chip 2 vom Typ InGaAlP mit einer Peakemissionswellenlänge von beispielsweise 620 nm und schließlich einem Halbleiterbauelement vom Typ Lumineszenzkonversions-LED mit einem dritten Chip 3 des Typs InGaN mit einer primären Peakemissionswellenlänge von beispielsweise 460 nm. Das Halbleiterbauelement 6 ist mit anderen ähnlichen Elementen in ein lichtundurchlässiges Grundgehäuse 8 eingebettet. Der Leuchtstoff ist das als Ausführungsbeispiel vorgestellte Oxinitridosilikat SrSi₂O₂N₂:Eu(10%), der die primäre Strahlung des Chips 3 vollständig konvertiert und in grüne Strahlung der Peakemission 547 nm mit λ_{dom} = 563 nm umwandelt. Diese Lösung hat den großen Vorteil, in einem weiten Bereich von Farbtemperaturen durch Änderung der relativen Intensitäten der drei LEDs per elektronischer Steuerung 7 durchstimmbar zu sein. Ein Vergleich, siehe Tab. 1, mit der bisher zur Verfügung stehenden Lösung mit drei primär emittierende LEDs (RGB, wobei grün durch eine InGaN-LED mit λdom= 526 realisiert wurde) zeigt eindrucksvoll die Überlegenheit der neuen Lösung. Fig. 3a zeigt eine LED 6 in Vergrößerung.

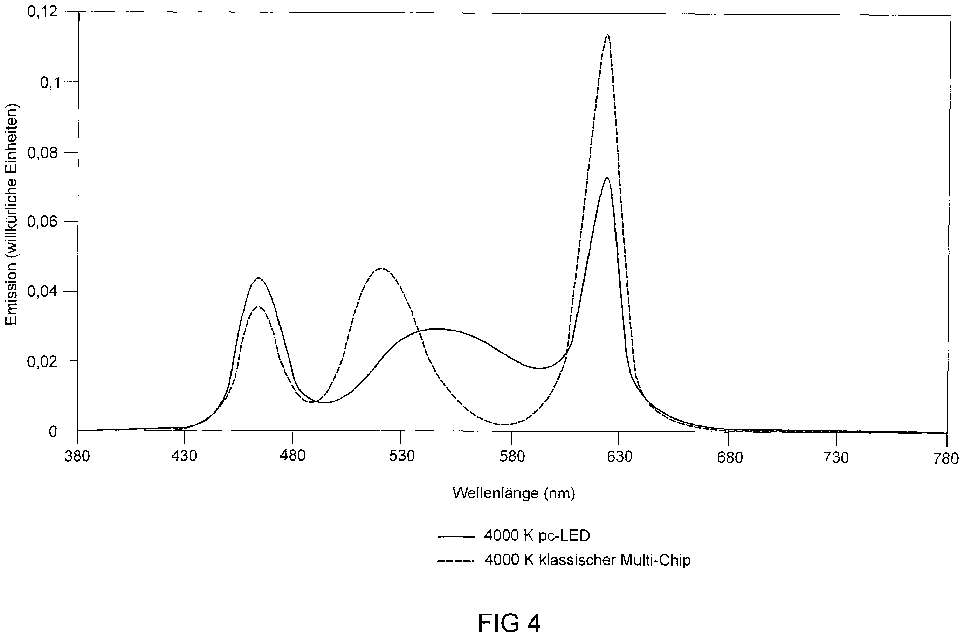

Figur 4 zeigt die Emission eines derartigen Beleuchtungssystems als spektrale Verteilung (Intensität in willkürlichen Einheiten) über die Wellenlänge (in nm). Die gestrichelte Linie zeigt die alte Lösung (drei primär emittierende LEDs) verglichen zur neuen Lösung (zwei primär emittierende LEDs und eine Lumineszenzkonversions-LED für grün) für eine Farbtemperatur von 4000 K.

Der besondere Vorteil der Verwendung einer langwelligen primären Lichtquelle (450 bis 465 nm) für die grüne Lumineszenzkonversions-LED ist, dass hier Probleme mit Alterung und Degradation von Gehäuse und Harz bzw. Leuchtstoff vermieden werden, so dass eine lange Lebensdauer erzielt wird.

In einem anderen Ausführungsbeispiel wird als primäre Lichtquelle eine UV-LED (etwa 380 nm) für die grüne Lumineszenzkonversions-LED verwendet, wobei hier Probleme mit Alterung und Degradation von Gehäuse und Harz bzw. Leuchtstoff durch zusätzliche an sich bekannte Maßnahmen möglichst weitgehend vermieden werden müssen wie sorgfältige Wahl des Gehäusematerials, Zugabe UV-resistenter Harzkomponenten. Der große Vorteil dieser Lösung ist die sehr hohe Effizienz von typisch 30 lm/W, die damit erzielbar ist.

**Tab. 1: Vergleich des Farbwiedergabeindex Ra sowie des roten Index R9 zwischen weiß emittierenden Halbleiterbauelementen auf Basis der reinen LED-Lösung (alt) und der Lösung mit grüner Lumineszenzkonversions-LED (neu)**

| Farbtemperatur (K) | Ra (alt) | R9 (alt) | Ra (neu) | R9 (neu) |
|---|---|---|---|---|
| 2700 | 38 | -23 | 91 | 92 |
| 3000 | 38 | -37 | 91 | 93 |
| 4000 | 43 | -71 | 94 | 89 |
| 5000 | 36 | -87 | 91 | 78 |
| 6430 | 51 | -99 | 86 | 57 |

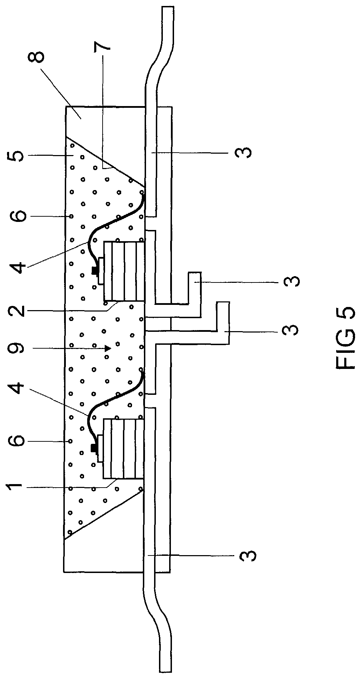

In einem weiteren Ausführungsbeispiel, siehe Figur 5, wird als weiß emittierendes Halbleiterbauelement eine Lösung mit zwei LEDs verwendet. Der prinzipielle Aufbau ist ähnlich wie in WO 01/41215 beschrieben. Eine erste Lumineszenzkonversions-LED stellt die blaue und grüne Komponente bereit. Ein Chip 1 des Typs InGaN mit einer primären Peakemissionswellenlänge von beispielsweise 460 nm ist in ein lichtundurchlässiges Grundgehäuse 8 im Bereich eines Hohlraums 9 eingebettet. Gleichzeitig ist in der Kavität 9 noch eine zweite LED 2 des Typs InGaAlP untergebracht, die rot emittiert, ähnlich der ersten Ausführungsform.

Die Chips besitzen getrennt steuerbare separate Anschlüsse 3. Jeweils einer der Anschlüsse 3 ist über einen Bonddraht 4 mit dem Chip 1, 2 verbunden. Die Ausnehmung hat eine schräge Wand 7, die als Reflektor für die Primärstrahlung der Chips 1, 2 dient. Die Ausnehmung 9 ist mit einer Vergussmasse 5 gefüllt, die als Hauptbestandteile (80 bis 90 Gew.-%) typisch ein Silikongießharz (oder auch Epoxidgießharz) und Leuchtstoffpigmente 6 (weniger als 15 Gew.-%) enthält. Weitere geringe Anteile entfallen u.a. auf Methylether und Aerosil. Der Leuchtstoff ist das als erstes Ausführungsbeispiel vorgestellte Oxinitridosilikat SrSi₂O₂N₂:Eu(10%) in geringerer Konzentration, der die primäre Strahlung der LED nur teilweise konvertiert und in grüne Strahlung der Peakemission 540 nm, bzw. λdom = 560 nm umwandelt.

Diese enge Bauform mit gemeinsamer Kavität ist möglich, weil die rote LED 2 mit primärer Emission bei 645 nm vom grünen Leuchtstoff nicht absorbiert bzw. konvertiert wird. Damit zeigt sich die Bedeutung einer engen Halbwertsbreite (FWHM unter 90 nm, bevorzugt unter 80 nm) exemplarisch. Der Nachteil dieser erstmalig vorgestellten extrem kompakten Lösung ist im Vergleich zur Drei-LED-Lösung lediglich die fehlende Durchstimmbarkeit.

Das Beleuchtungssystem eignet sich insbesondere auch für das Konzept der adaptiven Beleuchtung, bei der sich die Lichtfarbe oder auch die Helligkeit des Beleuchtungssystems nach frei wählbaren vorgegebenen Kriterien einstellen läst oder der Helligkeit der Umgebung in geeigneter Weise anpasst.

## Patentansprüche

1. Beleuchtungssystem auf LED-Basis unter gleichzeitiger Ausnutzung des Farbmischprinzips aus blau, grün und rot (RGB-Mischung) und des Prinzips der Konversion einer primär von einer LED emittierten Strahlung in längerwelliges Licht durch einen diese Strahlung absorbierenden Leuchtstoff, wobei mindestens zwei LEDs verwendet werden, von denen eine erste LED primär im Bereich 340 nm bis 470 nm (Peakwellenlänge), insbesondere mindestens 420 nm, emittiert und eine zweite LED im roten Bereich bei 600 bis 700 nm (Peakwellenlänge) emittiert, **dadurch gekennzeichnet, dass** die grüne Komponente dadurch erzeugt wird, dass die Primärstrahlung der ersten LED zumindest teilweise von einem grün emittierenden Leuchtstoff konvertiert wird, wobei als grün emittierender Leuchtstoff ein Leuchtstoff aus der Klasse der Oxinitridosilikate verwendet wird, mit einem Kation M und der grundsätzlichen Formel M_{(1-c)}Si₂O₂N₂ : D_{c}, und wobei M als Bestandteil Sr umfasst und M = Sr allein oder M = Sr_{(1-x-y)}Ba_{y}Caₓ mit 0 ≤ x+y < 0,5 verwendet wird, und wobei D mit zweiwertigem Europium dotiert ist, und wobei das Oxinitridosilikat vollständig oder überwiegend aus der hochtemperaturstabilen Modifikation HT besteht.

2. Beleuchtungssystem nach Anspruch 1, **dadurch gekennzeichnet, dass** das System Gruppen gleichartiger LEDs enthält.

3. Beleuchtungssystem nach Anspruch 1, **dadurch gekennzeichnet, dass** drei LEDs oder Gruppen von LEDs verwendet werden, wobei die Primärstrahlung der ersten LED vollständig in grüne Sekundäremission umgewandelt wird, wobei eine dritte LED blaues Licht emittiert, insbesondere mit einer Peakwellenlänge im Bereich 430 bis 470 nm.

4. Beleuchtungssystem nach Anspruch 1, **dadurch gekennzeichnet, dass** das System eine Steuerelektronik enthält, die Dimmbarkeit oder gezielte Steuerbarkeit von Eigenschaften des Systems wie die Lichtfarbe vermittelt.

5. Beleuchtungssystem nach Anspruch 3, **dadurch gekennzeichnet, dass** das System eine Steuerelektronik enthält, die die Helligkeit der einzelnen LEDs oder Gruppen von LEDs einzeln regelt, so dass ein durchstimmbares Beleuchtungssystem entsteht für einen Bereich an Farbtemperaturen, der mindestens 1000 K überdeckt innerhalb eines Bandes von 2500 bis 5000 K, mit einem Ra von mindestens 85, insbesondere mindestens 90, für jede gewählte Farbtemperatur innerhalb des gewählten Bereichs.

6. Beleuchtungssystem nach Anspruch 1, **dadurch gekennzeichnet, dass** genau zwei LEDs oder Gruppen von LEDs verwendet werden, wobei die Primärstrahlung der ersten LED nur teilweise in grüne Sekundäremission umgewandelt wird, wobei sowohl der grüne als auch der blaue Beitrag von der ersten LED emittiert wird.

7. Beleuchtungssystem nach Anspruch 1, **dadurch gekennzeichnet, dass** die grüne Sekundäremission eine dominante Wellenlänge im Bereich 550 bis 570 nm hat.

8. Beleuchtungssystem nach Anspruch 1, **dadurch gekennzeichnet, dass** beim Oxinitridosilikat der Anteil des Eu zwischen 0,1 und 20 mol-% von M ausmacht, also 0,001 < c < 0,2.

9. Beleuchtungssystem nach Anspruch 1, **dadurch gekennzeichnet, dass** Sr als M den überwiegenden Anteil stellt und ein Teil von M, insbesondere bis zu 30 mol-%, durch Ba und/oder Ca ersetzt ist.

10. Beleuchtungssystem nach Anspruch 1, **dadurch gekennzeichnet, dass** ein Teil von M bis zu 30 mol-% durch Li und/oder La und/oder Zn und/oder Na und/oder Y ersetzt ist.

11. Beleuchtungssystem nach Anspruch 1, **dadurch gekennzeichnet, dass** ein Teil von Eu bis zu 30 mol-% durch Mn ersetzt ist.

12. Beleuchtungssystem nach Anspruch 1, **dadurch gekennzeichnet, dass** als primäre Strahlungsquelle eine Leuchtdiode auf Basis von InGaN mit einer Peakwellenlänge im Bereich 420 bis 470 nm verwendet wird, die insbesondere ihre Peakwellenlänge im Bereich 440 bis 465 nm hat.

13. Beleuchtungssystem nach Anspruch 1, **dadurch gekennzeichnet, dass** durch die Farbmischung über das RGB-Prinzip ein weiß emittierendes Beleuchtungssystem mit einer Farbtemperatur von 2500 bis 5000 K, insbesondere 3500 bis 5000 K, realisiert wird.

14. Beleuchtungssystem nach Anspruch 1, **dadurch gekennzeichnet, dass** mehrere lichtemittierende Komponenten in einer Kavität angeordnet sind, insbesondere eine Lumineszenzkonversions-LED, die blaue und grüne Anteile der Emission gleichzeitig vermittelt, und eine LED, die rote Anteile der Emission direkt vermittelt.

15. Beleuchtungssystem nach Anspruch 1, **dadurch gekennzeichnet, dass** ein Anteil der NT-Modifikation oder von Fremdphasen so gering ist, daß die Halbwertsbreite des Oxinitridosilikats kleiner 90 nm ist.

16. Beleuchtungssystem nach Anspruch 1, **dadurch gekennzeichnet, dass** das System eine Elektronik zur Ansteuerung einzelner LEDs oder auch Gruppen von LEDs enthält.

## Claims

1. LED-based lighting system using simultaneously the colour mixing principle of blue, green and red (RGB mixture) and the principle of conversion of a radiation emitted primarily by an LED into longer-wave light by a phosphor absorbing this radiation, at least two LEDs being used, of which a first LED emits primarily in the range from 340 nm to 470 nm (peak wavelength), in particular at least 420 nm, and a second LED emits in the red range at 600 to 700 nm (peak wavelength), **characterized in that** the green component is generated by the primary radiation of the first LED being at least partially converted by a green-emitting phosphor, wherein as the green-emitting phosphor a phosphor from the class of oxynitride silicates is used, having a cation M and the basic formula M_{(1-c)}Si₂O₂N₂:D_{c}, and wherein M comprises Sr as a constituent and M = Sr alone or M = Sr_{(1-x-y)}Ba_{y}Caₓ with 0 ≤ x+y < 0.5 is used, and wherein D is doped with divalent europium, and wherein the oxinitride silicate consists completely or predominantly of the high-temperature-stable modification HT.

2. The lighting system according to claim 1, **characterized in that** the system contains groups of LEDs of the same type.

3. The lighting system according to claim 1, **characterized in that** three LEDs or groups of LEDs are used, wherein the primary radiation of the first LED is completely converted into green secondary emission, wherein a third LED emits blue light, in particular with a peak wavelength in the range 430 to 470 nm.

4. The lighting system according to claim 1, **characterized in that** the system contains control electronics which mediate dimmability or specific controllability of properties of the system such as the light colour.

5. The lighting system according to claim 3, **characterized in that** the system contains control electronics which individually regulate the brightness of the individual LEDs or groups of LEDs, so that a tunable lighting system is produced for a range of colour temperatures which covers at least 1000 K within a band of 2500 to 5000 K, with a Ra of at least 85, in particular at least 90, for each selected colour temperature within the selected range.

6. The lighting system according to claim 1, **characterized in that** exactly two LEDs or groups of LEDs are used, wherein the primary radiation of the first LED is only partially converted into green secondary emission, wherein both the green and the blue contribution is emitted by the first LED.

7. The lighting system according to claim 1, **characterized in that** the green secondary emission has a dominant wavelength in the range 550 to 570 nm.

8. The lighting system according to claim 1, **characterized in that** the proportion of Eu in the oxinitride silicate is between 0.1 and 20 mol% of M, i.e. 0.001 < c < 0.2.

9. The lighting system according to claim 1, **characterized in that** Sr represents the predominant proportion as M and a part of M, in particular up to 30 mol%, is replaced by Ba and/or Ca.

10. The lighting system according to claim 1, **characterized in that** a part of M up to 30 mol% is replaced by Li and/or La and/or Zn and/or Na and/or Y.

11. The lighting system according to claim 1, **characterized in that** a part of Eu up to 30 mol% is replaced by Mn.

12. The lighting system according to claim 1, **characterized in that** a light-emitting diode based on InGaN with a peak wavelength in the range 420 to 470 nm, which in particular has its peak wavelength in the range 440 to 465 nm, is used as the primary radiation source.

13. The lighting system according to claim 1, **characterised in that** a white-emitting lighting system with a colour temperature of 2500 to 5000 K, in particular 3500 to 5000 K, is realised by colour mixing using the RGB principle.

14. The lighting system according to claim 1, **characterized in that** a plurality of light-emitting components are arranged in a cavity, in particular a luminescence conversion LED which simultaneously transmits blue and green portions of the emission, and an LED which directly transmits red portions of the emission.

15. The lighting system according to claim 1, **characterized in that** a portion of the NT modification or of foreign phases is so small that the half width of the oxinitride silicate is less than 90 nm.

16. The lighting system according to claim 1, **characterized in that** the system contains electronics for controlling individual LEDs or also groups of LEDs.

## Revendications

1. Système d'éclairage à base de LED sous exploitation simultanée du principe de mélange de couleur à partir du bleu, du vert et du rouge (mélange RVB) et du principe de la conversion d'un rayonnement émis primairement par une LED en de la lumière à ondes plus longues par une matière luminescente absorbant ce rayonnement, au moins deux LEDs étant utilisées, dont une première LED émet primairement dans la plage de 340 nm à 470 nm (longueur d'ondes de pointe), notamment au moins 420 nm, et une seconde LED émet dans la plage rouge à 600 à 700 nm (longueur d'ondes de pointe), **caractérisé en ce que** le composant vert est généré **en ce que** le rayonnement primaire de la première LED est converti au moins partiellement par une matière luminescente émettant du vert, comme matière luminescente émettant du vert étant employée une matière luminescente issue de la classe des silicates d'oxynitrure, avec un cation M et la formule fondamentale M_{(1-c)}Si₂O₂N₂ : D_{c}, et dans laquelle M comporte du Sr comme composant et M = Sr seul ou M = Sr_{(1-x-y)}Ba_{y}Caₓ avec 0 ≤ x+y < 0,5 est utilisé, et dans laquelle D est doté d'europium bivalent, et le silicate d'oxynitrure se composant intégralement ou majoritairement de la modification HT stable aux hautes températures.

2. Système d'éclairage selon la revendication 1, **caractérisé en ce que** le système contient des groupes de LEDs de même type.

3. Système d'éclairage selon la revendication 1, **caractérisé en ce que** trois LEDs ou groupes de LEDs sont utilisés, le rayonnement primaire de la première LED étant converti entièrement en émission secondaire verte, dans lequel une troisième LED émet de la lumière bleue, notamment avec une longueur d'onde de pointe dans la plage de 430 à 470 nm.

4. Système d'éclairage selon la revendication 1, **caractérisé en ce que** le système contient une électronique de commande, qui transmet la gradation ou la maniabilité des propriétés du système comme la couleur de la lumière.

5. Système d'éclairage selon la revendication 3, **caractérisé en ce que** le système contient une électronique de commande, qui régule individuellement la luminosité des LEDs individuelles ou groupes de LEDs, de sorte qu'un système d'éclairage accordable est créé pour une plage de températures de couleurs, qui couvre au moins 1000 K au sein d'une bande de 2500 à 5000 K, avec un Ra d'au moins 85, notamment au moins de 90, pour chaque température de couleur sélectionnée au sein de la plage sélectionnée.

6. Système d'éclairage selon la revendication 1, **caractérisé en ce qu'**exactement deux LEDs ou groupes de LEDs sont utilisés, dans lequel le rayonnement primaire de la première LED est converti seulement partiellement en émission secondaire verte, aussi bien l'apport vert que le bleu étant émis par la première LED.

7. Système d'éclairage selon la revendication 1, **caractérisé en ce que** l'émission secondaire verte possède une longueur d'onde dominante dans la plage de 550 à 570 nm.

8. Système d'éclairage selon la revendication 1, **caractérisé en ce que** pour le silicate d'oxynitrure, la part de l'Eu constitue entre 0,1 et 20 % par mole de M, c'est-à-dire 0,001 < c < 0,2.

9. Système d'éclairage selon la revendication 1, **caractérisé en ce que** Sr représente en tant que M la part majoritaire et une partie de M, notamment allant jusqu'à 30 % par mole, est remplacée par du Ba et/ou du Ca.

10. Système d'éclairage selon la revendication 1, **caractérisé en ce qu'**une partie de M est remplacée allant jusqu'à 30 % par mole par du Li et/ou du La et/ou du Zn et/ou du Na et/ou du Y.

11. Système d'éclairage selon la revendication 1, **caractérisé en ce qu'**une partie de Eu est remplacée allant jusqu'à 30 % par mole par du Mn.

12. Système d'éclairage selon la revendication 1, **caractérisé en ce que**, comme source de rayonnement primaire, une diode luminescente est utilisée sur la base d'InGaN avec une longueur d'onde de pointe dans la plage de 420 à 470 nm, qui a notamment sa longueur d'onde de pointe dans la plage de 440 à 465 nm.

13. Système d'éclairage selon la revendication 1, **caractérisé en ce que** par le mélange de couleurs via le principe RVB un système d'éclairage émettant du blanc est réalisé avec une température de couleur de 2500 à 5000 K, notamment de 3500 à 5000 K.

14. Système d'éclairage selon la revendication 1, **caractérisé en ce que** plusieurs composants émetteurs de lumière sont disposés dans une cavité, notamment une LED à conversion de luminescence, qui transmet simultanément les parts bleues et vertes de l'émission, et une LED, qui transmet directement des parts rouges de l'émission.

15. Système d'éclairage selon la revendication 1, **caractérisé en ce qu'**une part de la modification NT ou des phases étrangères est si faible que la largeur à mi-hauteur du silicate d'oxynitrure est inférieure à 90 nm.

16. Système d'éclairage selon la revendication 1, **caractérisé en ce que** le système contient une électronique en vue de l'excitation de LEDs individuelles ou aussi de groupes de LEDs.
